# EUROPEAN PATENT APPLICATION

(11) **EP 2 824 463 A1**
(43) Date of publication of application: **14.01.2015**
(21) Application number: 13740993.4
(22) Date of filing: 21.01.2013
(51) Int. Cl.: G01R 15/22, G01D 5/353, G01K 11/12, G01R 19/03

(54) **OPTICAL FIBER FOR SENSOR AND POWER DEVICE MONITORING SYSTEM**

(30) Priority: 23.01.2012 JP 2012011250; 13.03.2012 JP 2012056060
(71) Applicant: KABUSHIKI KAISHA TOYOTA JIDOSHOKKI, Kariya-shi, Aichi 448-8671 (JP); National University Corporation Kagawa University, Takamatsu-shi, Kagawa 760-8521 (JP); Institute of National Colleges of Technology, Japan, Hachioji-shi, Tokyo 193-0834 (JP)
(72) Inventor: IMAOKA, Ko, Kariya-shi, Aichi 448-8671 (JP); SUZAKI, Yoshifumi, Takamatsu-shi, Kagawa 761-0396 (JP); IWATA, Hiromu, Takamatsu-shi, Kagawa 761-8058 (JP)
(74) Representative: TBK
(86) International application number: PCT/JP2013/051070
(87) International publication number: WO 2013/111699

(57) **Abstract**

An optical fiber for a sensor that can measure a current or a voltage precisely is provided. The optical fiber for the sensor 10 comprises: an FBG 12 wherein a refractive index of a core changes periodically; a metal layer 13 for sheathing the FBG 12; and a pair of electrodes 14 and 15 provided at the metal layer 13. The electrodes 14 and 15 are connected to an object to be measured in desired positions. Current flowing through the metal layer 13 is calculated based on variation in Bragg wavelength of the FBG 12.

## Description

### Technical Field

The present invention relates to an optical fiber for a sensor and a power device monitoring system comprising the optical fiber for the sensor.

### Background Art

Measurement of current or voltage is necessary for monitoring conditions of batteries, generators, etc. Conventional current or voltage sensors perform measurement for example based on the principle of electromagnetic induction.

Also, optical fibers are utilized as sensors for measuring temperature, not current or voltage, wherein an FBG (Fiber Bragg Grating) is formed. The FBG is a refraction grating wherein the refractive index of a core of the optical fiber changes in a predetermined period length (i.e. a grating period) along an axial direction and has characteristics where it reflects light of a particular wavelength (i.e. a Bragg wavelength) corresponding to the grating period with respect to light incident to the optical fiber and transmits other light. If the FBG experiences thermal expansion in response to temperature variation, the grating period also varies accordingly. The Bragg wavelength varies linearly with respect to variations in the grating period, so the temperature can be measured based on the amount of variation in the Bragg wavelength. Also, multi-point temperature measurement for measuring temperatures at a plurality of positions can be performed if a plurality of FBGs are formed on a single optical fiber. For example, Patent Document 1 discloses a temperature measurement system that uses a laser as a source of light incident to an optical fiber and measures temperatures with a plurality of FBGs provided at an outer panel of an aircraft.

Additionally, as an example of a construction for optical fibers which are not used for temperature sensors, Patent Document 2 describes an optical component wherein the external periphery of a cladding layer in an optical fiber is metalized.

### Conventional Art Documents

### [Patent Documents]

[Patent Document 1] Japanese National Phase Publication No. 2009-516855
[Patent Document 2] Japanese Patent Application Laid Open No. 2004-29691

### Summary of the Invention

### Problems to be solved by the Invention

However, conventional current sensors or voltage sensors have a problem in that measurement with high precision is difficult because errors included in the measured values are relatively large.

Also, conventional optical fibers for sensors have a problem in that they cannot measure any current or voltage. For example, Patent Documents 1 and 2 do not describe measuring current or voltage using the optical fiber. Further, the optical fibers described in
Patent Documents 1 and 2 cannot measure any current or voltage if they are used without any modification.

The present invention is made in order to solve these problems and is aimed at providing an optical fiber for a sensor and a power device monitoring system that can measure a current or a voltage with high precision.

### Means for Solving the Problems

In order to solve the above problem, an optical fiber for a sensor related to the present invention comprises:
an FBG wherein a refractive index of a core of the optical fiber for the sensor changes periodically along a direction in which incident light propagates;
a metal layer for sheathing the FBG; and
a pair of electrodes provided at the metal layer.

According to such a construction, if a current to be measured (or a current corresponding to a voltage to be measured) flows through a metal layer, the amount of heat produced in the metal layer varies in response to the magnitude of the current. Also, the FBG expands in response to the amount of heat produced in the metal layer and to stress of expansion due to the heat of the metal layer so that the Bragg wavelength changes, and so the wavelength of light transmitting the FBG changes accordingly.

The metal layer may include a resistive metal material.

The metal layer may expand and contract in the direction in which the incident light propagates from Joule heat produced in the metal layer.

The optical fiber for the sensor may comprise a plurality of the FBGs; and
one of the electrodes of the metal layer for one of the FBGs may be connected to a resistor.

The optical fiber for the sensor may comprise an environmental temperature sensor portion; and
the environmental temperature sensor portion may comprise another FBG.

The FBG may comprise a metalized portion which is sheathed by the metal layer and a non-metalized portion which is not sheathed by the metal layer.

The total length of the metalized portion in the direction in which the incident light propagates and the total length of the non-metalized portion(s) in the direction in which the incident light propagates may be equal to each other.

The metalized portion may be provided at the center of the FBG in the direction in which the incident light propagates.

Also, a power device monitoring system related to the present invention comprises:
the above optical fiber for the sensor;
a light source for emitting light constituted by a plurality of wavelengths as the incident light;
spectroscopic means for measuring a bandwidth of light that has transmitted through the FBG or wavelengths reflected by the FBG; and
calculation means for calculating a current flowing through the metal layer or a voltage applied to the metal layer based on the bandwidth.

Also, a power device monitoring system related to the present invention comprises:
the above optical fiber for the sensor;
a light source for emitting the incident light; and
light measurement means for measuring light that has transmitted through the FBG or light reflected by the FBG.

The optical fiber for the sensor may comprise a plurality of FBGs;
the plurality of FBGs may include an FBG for current and an FBG for voltage;
the metal layer of the FBG for current may be connected in series with the power device;
one of the electrodes of the metal layer of the FBG for voltage may be connected to a resistor; and
the metal layer of the FBG for voltage may be connected in parallel with the power device.

The light source may emit light constituted by a plurality of wavelengths as the incident light; and
the light measurement means may be spectroscopic means for measuring a spectrum of light.

The spectroscopic means may identify a Bragg wavelength reflected by the FBG; and
the power device monitoring system may calculate current flowing through the metal layer or voltage applied to the metal layer based on the Bragg wavelength.

The optical fiber for the sensor may comprise an environmental temperature sensor portion;
the environmental temperature sensor portion may comprise another FBG;
the spectroscopic means may identify a wavelength reflected by the environmental temperature sensor portion as a reference Bragg wavelength; and
the calculation means may calculate the current or the voltage based on a difference between the Bragg wavelength and the reference Bragg wavelength.

### Effect of the Invention

According to the optical fiber for the sensor and the power device monitoring system of the present invention, the amount of heat produced in the metal layer differs depending on the current to be measured or the current corresponding to the voltage to be measured, and the Bragg wavelength of the FBG varies in response to this, thereby enabling measurement of the current or the voltage in an optical manner so that the precision is improved.

### Brief Description of the Drawings

Fig. 1 is a diagram illustrating a construction of a power device monitoring system related to a first embodiment of the present invention.
Fig. 2 is a diagram illustrating expansion of the FBG of Fig. 1.
Fig. 3 is a diagram illustrating how a spectrum of light that has transmitted through the optical fiber for the sensor of Fig. 1 varies.
Fig. 4 is a diagram illustrating a construction of a power device monitoring system related to a second embodiment.
Fig. 5 is an enlarged view of portions of the optical fiber for the sensor of Fig. 4.
Fig. 6 is a diagram showing the relationship among the Bragg wavelengths of the FBGs in Fig. 4.
Fig. 7 is an enlarged view of a portion of the optical fiber for the sensor related to a third embodiment.
Fig. 8 is a diagram illustrating how a spectrum of light reflected by the FBGs varies in response to energization of a metal layer.
Fig. 9 is a diagram illustrating an alternative embodiment of the optical fiber for the sensor of Fig. 7.

### Embodiments of the Invention

Embodiments of the present invention will be explained below with reference to the attached drawings.

### First Embodiment

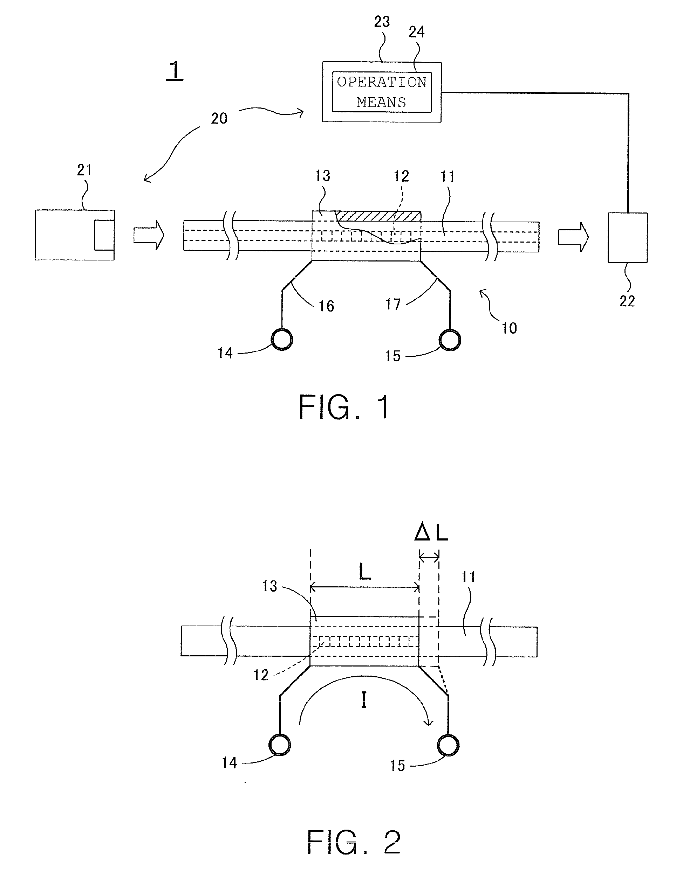

Fig. 1 is a schematic diagram illustrating a general construction of a power device monitoring system 1 related to a first embodiment of the present invention.

The power device monitoring system 1 is used in order to monitor a power device by measuring a current or a voltage of the power device. The power device means for example an electrical power device and includes a battery, a rechargeable battery, a generator, a transformer, etc. Also, the power device may be a high voltage electric circuit or a part thereof.

The power device monitoring system 1 comprises an optical fiber for a sensor 10 and a light processing device 20. The optical fiber for the sensor 10 has a construction as a known optical fiber. For example, the optical fiber for the sensor 10 comprises a core and cladding as constructions for propagating incident light toward a predetermined direction.

The optical fiber for the sensor 10 comprises an optical fiber portion 11 having a construction as a normal optical fiber and an FBG 12. The refractive index of the core in the optical fiber portion 11 is supposed to be constant in the example of FIG. 1. The refractive index of the core in the FBG 12 changes periodically with a predetermined period length (i.e. a grating period) along a direction in which the incident light propagates. Accordingly, the FBG 12 has characteristics that it reflects light of a specific wavelength determined in response to the grating period (i.e. a Bragg wavelength) with respect to the incident light and transmits the other light. Also, the optical fiber portion 11 and the FBG 12 are formed for example of materials such as quartz glass and have positive coefficients of thermal expansion. Further, as an example, the FBG 12 is formed by radiating ultraviolet light or the like on a core of an optical fiber.

The optical fiber for the sensor 10 comprises a metal layer 13 for sheathing the FBG 12. Also, the optical fiber for the sensor 10 comprises a pair of electrodes 14 and 15 provided at the metal layer 13. The electrodes 14 and 15 are connected to the metal layer 13 in different positions by wires 16 and 17 respectively. A current can flow in the metal layer 13 by applying a voltage between the electrodes 14 and 15.

The metal layer 13 is a heating element including a resistive metal material having a constant resistance. For example, the metal layer 13 may be constituted solely by the resistive metal material. Examples of the resistive metal material are titanium, nichrome, stainless steel, silver, etc. Also, the resistive metal material can be a material mixing titanium, nichrome or stainless steel with copper. The metal layer 13 is cylindrically formed around the external periphery of the FBG 12. In the present embodiment, the Bragg-processed portion is entirely sheathed by the metal layer 13. However, the metal layer 13 does not have to sheath an entire portion of the FBG 12 completely but may sheath at least a portion of the FBG 12. Further, the metal layer 13 is for example formed on a cladding layer of the FBG 12 to sheath the cladding layer, but it does not have to sheath the cladding layer directly.

In accordance with such a construction, if a current flows through the metal layer 13, the FBG 12 expands by heat produced in the metal layer 13. This will be explained using Fig. 2.

Fig. 2 is a diagram illustrating expansion of the FBG 12. The figure explains that length L of the FBG 12 and the metal layer 13 in an axial direction (i.e. a direction wherein the incident light propagates) increases by ΔL by current I flowing though the metal layer 13. If Joule heat is produced in the metal layer 13, the FBG 12 is heated to expand in the axial direction by thermal stress. Also, the metal layer 13 per se expands by this Joule heat so that the metal layer 13 expands in the axial direction, and stress upon this expansion makes the FBG 12 expand in the axial direction. As a result of these effects, the length L of the FBG 12 expands by ΔL.

Although Fig. 2 shows that the metal layer 13 expands only in a rightward direction, the metal layer 13 actually expands to both sides in the axial direction. Thus, the FBG 12 and the metal layer 13 expand and contract by Joule heat.

In response to variations in the length of the FBG 12, the grating period of the FBG 12 also varies. The grating period is a factor for defining the Bragg wavelength of the FBG 12 and the Bragg wavelength will vary linearly with respect to the amount of variation in the grating period. In other words, if the FBG 12 expands, the grating period increases, and accordingly the Bragg wavelength shifts towards a longer wavelength side. On the contrary, if the temperature of the FBG 12 drops and the FBG 12 contracts, the grating period decreases, and accordingly the Bragg wavelength shifts towards a shorter wavelength side. Thus, the numerical value representing the temperature of the FBG 12 can be measured based on the amount by which the Bragg wavelength shifts.

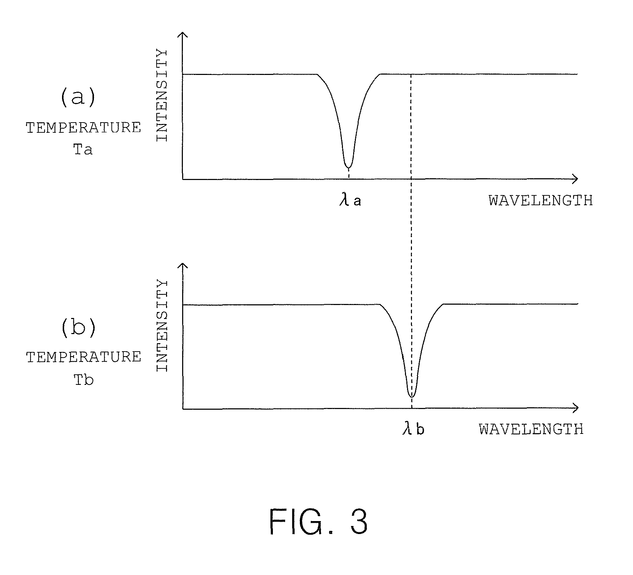

Fig. 3 illustrates how a spectrum of light that has transmitted through the optical fiber for the sensor 10 varies in response to the variation in the Bragg wavelength. Fig. 3 (a) shows a spectrum of the transmitted light at temperature Ta and Fig. 3(b) shows a spectrum of the transmitted light at temperature Tb, wherein Ta<Tb. Note that, since a real light source is not an ideal white light source, the spectra would not be as flat as shown in Fig. 3 and would decrease in both the long and short wavelength sides. However, the shapes shown in Fig. 3 are used herein for the sake of explanation. The wavelength band utilized in the present embodiment is sufficiently narrow, so there is no need for an ideal white light source. An emitted wavelength band that is broad enough to be regarded as flat in the utilized range is sufficient.

As shown in Fig. 3(a), wavelength λa corresponds to the Bragg wavelength at temperature Ta. Because the FBG 12 reflects most light having the wavelength λa, light having the wavelength λa and nearby wavelengths is not transmitted through the optical fiber for the sensor 10, so the spectrum of the transmitted light shows a local minimum value at the wavelength λa as a result.

If the temperature of the FBG 12 rises from Ta to Tb, the Bragg wavelength shifts towards the longer wavelength side, to e.g. λb. In this case, light having the wavelength λb and nearby wavelengths is not transmitted through the optical fiber for the sensor 10, so the spectrum of the transmitted light shows a local minimum value at the wavelength λb as a result.

Referring to Fig. 1 again, the construction of the light processing device 20 will be explained.

The light processing device 20 comprises a light source 21 and light measurement means 22. The light source 21 emits incident light toward the optical fiber for the sensor 10. The light source 21 is for example a laser diode but may be another light source or may be a non-laser LED. The light source 21 emits light having a continuous spectrum as shown in Fig. 3. That is, the incident light is constituted by a plurality of wavelengths.

The light measurement means 22 receives and measures the light that has transmitted through the optical fiber for the sensor 10. The light measurement means 22 has a function to measure the spectrum of light that has transmitted through the optical fiber for the sensor 10 and can be constructed by a known spectroscopic means. For example, the light measurement means 22 comprises a plurality of filters having respectively different wavelength characteristics and light intensity measurement means for measuring intensities of lights that has transmitted through the respective filters, and transforms the light intensities in respective wavelengths into electric signals. Here, the light intensity measurement means can be constructed by using a MOS or a CCD. Thus, the light measurement means 22 can identify the wavelength reflected by the FBG 12 (i.e. the Bragg wavelength of the FBG 12). For example, the wavelength which has a local minimum value in the spectrum can be identified as the Bragg wavelength.

Also, the light processing device 20 comprises a control portion 23 connected to the light measurement means 22. The control portion 23 comprises operation means 24 for performing operations based on a signal received from the light measurement means 22. The operation means 24 can calculate the magnitude of the current flowing through the metal layer 13 based on the Bragg wavelength of the FBG 12.

For example, the amount of heat produced in the metal layer 13 is determined in response to the magnitude of the current flowing through the metal layer 13 and the amount of heat produced in the metal layer 13 is in proportion to the heat stress exerted on the FBG 12, so the amount of variation in the Bragg wavelength (i.e. difference from a predetermined reference Bragg wavelength) would depend on the magnitude of the current flowing through the metal layer 13. The operation means 24 can calculate the magnitude of current based on an equation representing this relationship. Also, the reference Bragg wavelength and the equation can, for example, be stored in the operation means 24 beforehand.

Thus, the power device monitoring system 1 related to the first embodiment of the present invention can measure the value of the current flowing through the metal layer 13, so it can be utilized as a current sensor by connecting the electrodes 14 and 15 of the metal layer 13 to desired positions of an object to be measured. Here, the power device monitoring system 1 measures the current value optically based on the variation in the Bragg wavelength, so the measurements can be performed with high precision without any effects such as electromagnetic noise.

Also, the Bragg-processed portion (including the entire portion of the FBG 12) is sheathed entirely by the metal layer 13, so the reflected wavelength band is not distorted.

Further, because the resistance value of the metal layer 13 is known, the power device monitoring system 1 can transform the current value into a voltage value. In other words, the operation means 24 in this case has a function for calculating the voltage applied to the metal layer 13 based on the Bragg wavelength of the FBG 12.

### Second Embodiment

The first embodiment did not consider any expansion and contracting of the FBG 12 due to variations in environmental temperature. The second embodiment considers variations in environmental temperature and has a construction that can perform the measurement with still higher precision.

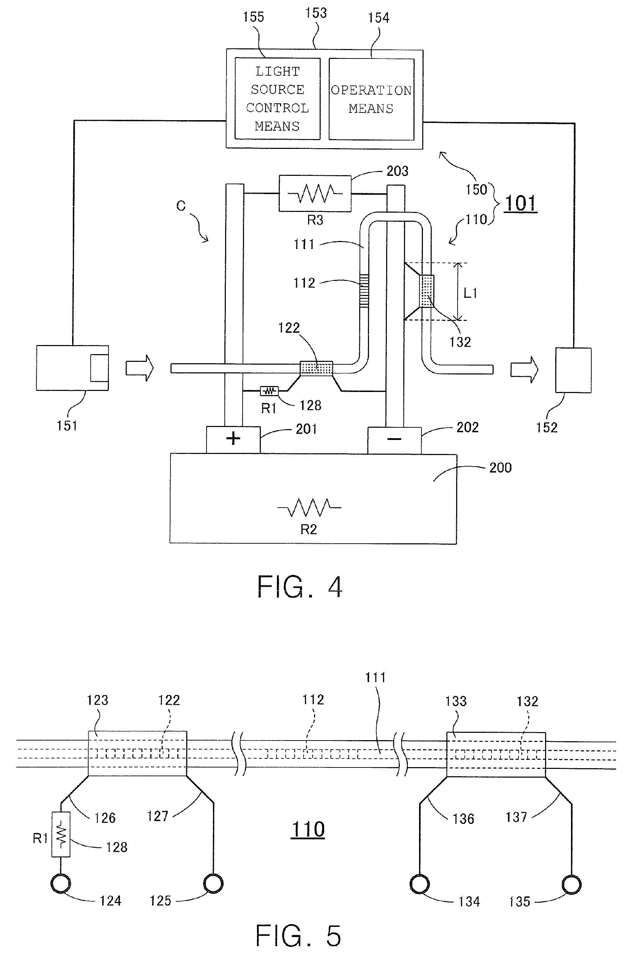

Fig. 4 illustrate constructions of a power device monitoring system 101 related to the second embodiment and a battery 200 as an example of a power device to be monitored. The power device monitoring system 101 comprises an optical fiber for a sensor 110 and a light processing device 150. The optical fiber for the sensor 110 comprises an optical fiber portion 111 and three FBGs. The three FBGs are an FBG for temperature assurance 112, an FBG for voltage 122 and an FBG for current 132. In the present embodiment, the three FBGs all have identical characteristics (length, material, grating period, coefficient of thermal expansion, etc.).

Fig. 5 is an enlarged view of portions of the optical fiber for the sensor 110. The FBG for temperature assurance 112, the FBG for voltage 122 and the FBG for current 132 are all provided in a core of the same optical fiber for the sensor 110. That is, these three FBGs are provided on an identical light path. In accordance with such a construction, only light that has transmitted through all of the FBG for temperature assurance 112, the FBG for voltage 122 and the FBG for current 132 can be measured by a light measurement means 152.

The FBG for temperature assurance 112 has a construction similar to that of an FBG used as a conventional temperature sensor. For example, the FBG for temperature assurance 112 is not sheathed by any metal layer (however, the present invention does not exclude a construction wherein a metal layer sheathing is provided). As shown, the FBG for temperature assurance 112 is an FBG other than the FBG for voltage 122 and the FBG for current 132 and functions as an environmental temperature sensor portion for measuring the temperature of an ambient environment.

A metal layer 123 and a metal layer 133 are provided for sheathing the FBG for voltage 122 and the FBG for current 132 respectively in a manner similar to the first embodiment.

Regarding the FBG for voltage 122, the metal layer 123 is provided with a pair of electrodes 124 and 125 which are connected to the metal layer 123 in different positions by wires 126 and 127 respectively. One of the electrodes (the electrode 124 in the example of Fig. 5) is inserted into a resistor 128 having a resistance value of R1 via the corresponding wire 126.

Also, regarding the FBG for current 132, the metal layer 133 is provided with a pair of electrodes 134 and 135 which are connected to the metal layer 133 in different positions by wires 136 and 137 respectively. In contrast to the FBG for voltage 122, no resistor is inserted into the FBG for current 132.

Referring to Fig. 4 again, the construction of the light processing device 150 will be explained.

The light processing device 150 comprises a light source 151, a light measurement means 152 and a control portion 153. The light source 151 emits an incident light to the optical fiber for the sensor 110 and the light measurement means 152 receives and measures light that has transmitted through the optical fiber for the sensor 110, in a manner similar to the first embodiment. The control portion 153 comprises operation means 154 and a light source control means 155.

The battery 200 comprises a cathode 201 and an anode 202 and a load 203 is connected between the cathode 201 and the anode 202. Thus, the battery 200 and the load 203 constitute an electric circuit C. Here, it is given that the battery 200 has an internal resistance R2 and that the load 203 is equivalent to a resistance R3. Also, it is given that the resistance value of the metal layer 123 of the FBG for voltage 122 is Rv and the resistance value of the metal layer 133 of the FBG for current 132 is Ri (Rv and Ri may be equal). In this case, it is preferable to design the relationship among the resistances so that e.g. R1 >> R3 >> R2, Rv, Ri, but the relationship is not limited to this.

The metal layer 123 and the resistor 128 of the FBG for voltage 122 are connected in parallel with respect to the battery 200 in the electric circuit C. Also, the metal layer 133 of the FBG for current 132 is connected in parallel with respect to the battery 200 in the electric circuit C. The FBG for temperature assurance 112 is independent of the electric circuit C. According to such a construction, the Bragg wavelength of the FBG for temperature assurance 112 would be a wavelength corresponding to ambient temperature, the Bragg wavelength of the FBG for voltage 122 would be a wavelength corresponding to the sum of the ambient temperature and a temperature corresponding to the heat produced in the metal layer 123 and the Bragg wavelength of the FBG for current 132 would be a wavelength corresponding to the sum of the ambient temperature and a temperature corresponding to the heat produced in the metal layer 133.

In the second embodiment, the electrodes 134 and 135 of the FBG for current 132 are connected so that the length L1 (Fig. 4) of the portion between them is always constant in the electric circuit C. In an alternative embodiment, the length L1 can be adjusted so that the resistance value of the portion is always constant. Any construction can be used if the operation means 154 can obtain or calculate the resistance value of the corresponding portion in the electric circuit C.

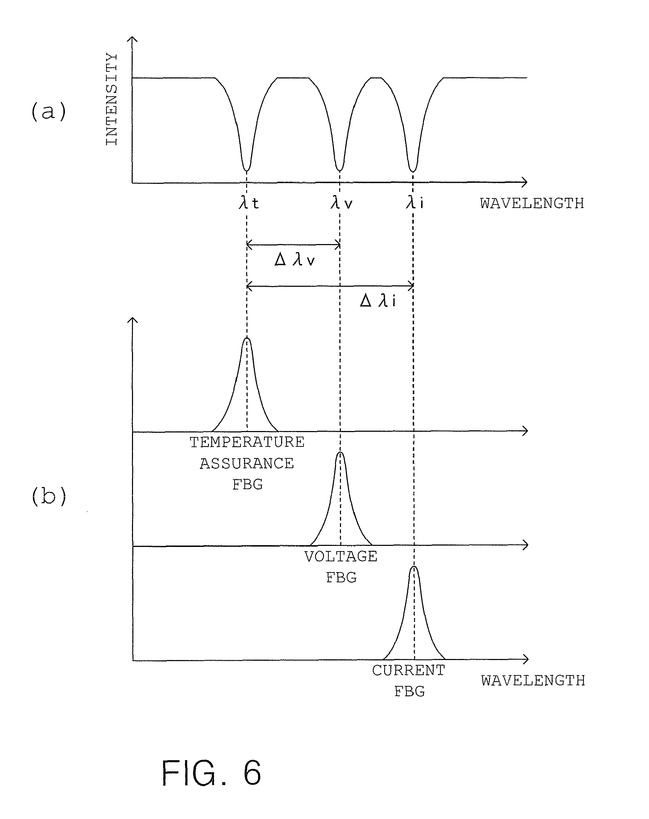

Next, an operation of the power device monitoring system 101 related to the second embodiment will be explained using Fig. 6.

Fig. 6 illustrates the relationship among the Bragg wavelengths of the FBGs. Fig. 6(a) illustrates a spectrum around the Bragg wavelength λt of the FBG for temperature assurance 112 enlarged schematically in a direction of the wavelength. Fig. 6(b) shows spectra of light reflected by the three FBGs respectively. Three local minimum values appear in the spectrum measured by the light measurement means 152 as shown in Fig. 6(a) because the three FBGs reflect the light at respectively different Bragg wavelengths as shown in Fig. 6(b).

The operation means 154 calculates current and voltage related to the battery 200 based on respective Bragg wavelengths λt, λv and λi. The calculation can be performed for example as follows. The operation means 154 first obtains the local minimum value that has the shortest wavelength among the three local minimum values appearing in the spectrum as the Bragg wavelength λt of the FBG for temperature assurance 112. Then, it obtains the next shortest wavelength as the Bragg wavelength λv of the FBG for voltage 122, and then the next shortest wavelength (i.e. the longest wavelength) as the Bragg wavelength λi of the FBG for current 132.

Next, it calculates the difference Δλv=λv-λt for compensating errors due to environmental temperature and calculates current flowing through the metal layer 123 of the FBG for voltage 122 based on the difference Δλv. Further, it calculates voltage between the electrodes 124 and 125 of the metal layer 123 based on the current flowing through the metal layer 123 and the resistance value R1 of the resistor 128. This voltage is the voltage between the cathode 201 and the anode 202 of the battery 200. Thus, the power device monitoring system 101 measures the voltage value of the battery 200.

Similarly, the operation means 154 calculates the difference Δλi=λi-λt for compensating errors due to environmental temperature and calculates current flowing through the metal layer 133 of the FBG for current 132 based on the difference Δλi. Further, based on this current, the resistance value Ri of the metal layer 133 (which may be stored beforehand) and the resistance value between the electrodes 134 and 135 in the electric circuit C, it calculates current flowing through the electric circuit C. Thus, the power device monitoring system 101 measures the current value of the battery 200.

Thus, the power device monitoring system 101 related to the second embodiment of the present invention can measure the current and the voltage of the battery 200, so it can monitor conditions of the battery 200. The power device monitoring system 101 measures the current value and the voltage value optically based on the variation in the Bragg wavelengths in a manner similar to the first embodiment, so they can be measured with high precision.

Also, the second embodiment uses the differences Δλi=λi-λt and Δλv=λv-λt with respect to the Bragg wavelength λt corresponding to the environmental temperature instead of the absolute values of the Bragg wavelengths λi and λv, so the errors due to variations in the environmental temperature can be compensated, and thus can be measured with still higher precision.

Also, no current flows in or around the FBG for temperature assurance 112, so the temperature of the FBG for temperature assurance 112 per se does not vary between when the power device monitoring system 101 is operating and when it is not. That is, no workload is required to warm up the FBG for temperature assurance 112 or stabilizing the FBG for voltage 122 with respect to the environmental temperature. Further, variation of the Bragg wavelengths in the FBGs and their measurements are optical factors and not under electromagnetic interference, so the measurements can be performed with a high S/N ratio without any electromagnetic noise.

Also, the wavelength corresponding to the environmental temperature (the reference Bragg wavelength λt) and the wavelengths corresponding to the current and the current (the Bragg wavelengths λi and λv) are measured based on variation in the Bragg wavelengths of the FBGs, i.e. based on the same physical principle, so their error compensation can be more precise.

The following modifications can be made on the above first and second embodiments.

In the first and second embodiments, the light processing device measures the current and/or the voltage based on the light that has transmitted through the FBGs. In an alternative embodiment, the light processing device may measure the current or the voltage based on the light reflected by the FBGs. In this case, the light measurement means would be provided at the incident side of the optical fiber for the sensor to measure the spectra of light reflected by the FBGs. Further, the Bragg wavelengths would be identified as the wavelengths giving local maximum values in the measured spectra.

The wire 16 of the metal layer 13 of the first embodiment (Fig. 1) may be provided with a resistor corresponding to the resistor 128 in the second embodiment (Fig. 5). In this case, the power device monitoring system 1 of the first embodiment can measure the voltage more precisely. Also, the optical fiber for the sensor may comprise both an FBG thus provided with the resistor and an FBG which is not provided with such a resistor (i.e. the FBG 12 shown in Fig. 1). The construction comprising both FBGs would be equivalent to the optical fiber for the sensor 110 of the second embodiment (Fig. 4) wherein the FBG for temperature assurance 112 is omitted.

Although three FBGs are used in the second embodiment, at least two FBGs are sufficient. For example, one of the FBG for voltage 122 and FBG for current 132 may be omitted. In this case, the power device monitoring system 101 would measure either one of the current and the voltage of the battery 200.

Although the FBG for current 132 is connected in parallel with a portion of the electric circuit C in the second embodiment, it may be connected in series with the electric circuit C in a manner similar to a conventional ammeter. In this case, the operation means 154 can measure the value of the current flowing through the metal layer 133 of the FBG for current 132 directly as the current value of the battery 200.

Although the FBG for temperature assurance 112, the FBG for voltage 122 and the FBG for current 132 have identical characteristics in the second embodiment, they may have respectively different characteristics. For example, they may have respectively different coefficients of thermal expansion or respectively different grating periods at the same temperature. Even in such constructions, the operation means 154 can calculate the current value and the voltage value by appropriate operations if their respective characteristics are known.

### Third Embodiment

The third embodiment enables the temperature assurance (temperature compensation) by a single FBG by providing a current detection portion and a temperature detection portion within the single FBG and performing operations based on a reflected bandwidth.

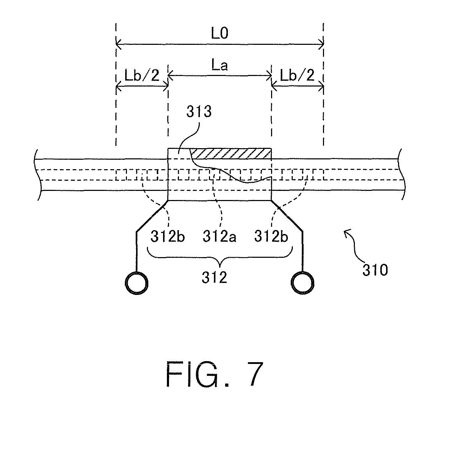

Fig. 7 is an enlarged view of a portion of the optical fiber for the sensor 310 related to the third embodiment. Differences from the optical fiber for the sensor 10 of the first embodiment (Fig. 1, Fig. 2) will be explained below.

The optical fiber for the sensor 310 comprises a metal layer 313 for sheathing an FBG 312. The metal layer 313 is formed for example by metal vapor deposition.

L0 denotes an axial length of the FBG 312. Unlike the first embodiment, the metal layer 313 does not sheath an entire portion of the FBG 312 but only sheaths a portion thereof. In other words, the FBG 312 comprises a metalized portion 312a sheathed by the metal layer 313 and non-metalized portions 312b which are not sheathed by the metal layer 313. (Note that the non-metalized portions 312b do not have to be exposed and may be sheathed by a structure other than a metal layer.)

The grating period is constant throughout the entire FBG 312. That is, the grating period of the metalized portion 312a and the grating period of the non-metalized portions 312b are the same. In the present embodiment, the metalized portion 312a functions as the current detection portion and the non-metalized portions 312b function as the temperature detection portions.

The metalized portion 312a is provided at the center in an axial direction of the FBG 312 and has axial length La. The non-metalized portions 312b are provided at opposite sides with respect to the metalized portion 312a in the axial direction of the FBG 312 and have axial length Lb/2 at the respective sides. That is, a total length of the non-metalized portions 312b is Lb and L0=La+Lb.

In the present embodiment, La and Lb are equal. In other words the total length of the metalized portion 312a (the total length is La because there is a single metalized portion 312a in the example of Fig. 7) is equal to the total length of the non-metalized portions 312b. Thus, the metalized portion 312a and the non-metalized portions 312b have equal grating periods and equal lengths, so they would have identical spectral characteristics at the same temperature.

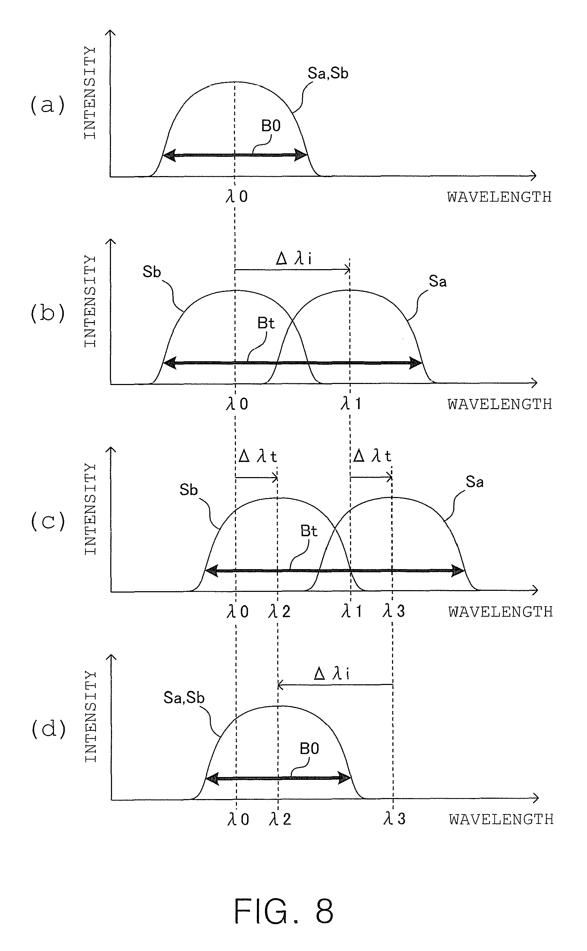

Fig. 8 illustrates how a spectrum of light reflected by the FBG 312 varies in response to energization of the metal layer 313. Fig. 8(a) represents a condition before energization. The entire portion of the FBG 312 is at a temperature before energization (e.g. a room temperature). In other words, the reflected spectrum Sa of the metalized portion 312a and the reflected spectrum Sb of the non-metalized portions 312b match. λ0 denotes the peak wavelength in this condition. Also, B0 denotes the bandwidth of wavelengths reflected by the entire portion of the FBG 312. The bandwidth B0 can be measured by a known method and is for example a width of a band wherein intensity of reflected light is equal to or greater than a predetermined threshold.

Fig. 8(b) represents a condition immediately after energization of the FBG 312 has begun. Immediately after energization has begun, the temperature of only the metalized portion 312a rises rapidly and the reflected spectrum Sa shifts towards the longer wavelength side due to thermal expansion. Here, it is given that the reflected spectrum Sa shifts by Δλi so that the peak wavelength becomes λ1=λ0+Δλi. At this time, the temperature of the non-metalized portions 312b has not risen, so the reflected spectrum Sb remains the same.

Thus, only the reflected spectrum Sa of the metalized portion 312a shifts, so as a result the width of the reflected spectrum is broadened for the entire FBG 312. At this time, if the bandwidth of the wavelengths reflected by the entire FBG 312 is Bt, Bt=B0+Δλi. Accordingly, Δλi can be calculated by measuring B0 and Bt (e.g. Δλi=B2-B0). Also, Δλi would depend on the magnitude of the current, so the magnitude of the current can be calculated based on Δλi.

For example, a power device monitoring system can be constructed so that it comprises the light source for emitting light as incident light constituted by a plurality of wavelengths, the light measurement means (spectroscopic means) for measuring the bandwidth Bt of the wavelengths reflected by the FBG 312 and the calculation means for calculating the current flowing through the metal layer 313 based on the measured bandwidth Bt. The voltage applied to the metal layer 313 can also be calculated similarly. The control portion may store beforehand the bandwidth B0 of the wavelengths reflected by the FBG312 in case the current is zero.

Fig. 8(c) represents a condition wherein the energization of the metal layer 313 has continued for a while. Heat is propagated from the metalized portion 312a to an entire portion of the optical fiber for the sensor 310 so that both the reflected spectra Sa and Sb of the metalized portion 312a and the non-metalized portions 312b shift towards the longer wavelength side. Here, it is given that they shift by Δλt. As a result, the peak wavelength of the reflected spectrum of the metalized portion 312a becomes λ3=λ1+Δλt and the peak wavelength of the reflected spectrum Sb of the non-metalized portions 312b becomes λ2=λ0+Δλt.

In such a condition, even if the current flowing through the metal layer 313 is constant, the peak wavelength of the reflected spectrum Sa of the metalized portion 312a varies as time passes, so some correction would be necessary in order to calculate the current value precisely based only on the peak wavelength of the reflected spectrum Sa.

However, the shift of Δλt similarly appears for the metalized portion 321a and the non-metalized portions 312b, so the reflected spectrum of the entire FBG 312 shifts towards the longer wavelength side whereas its shape remains unchanged. Accordingly, the bandwidth of the wavelengths reflected by the entire FBG 312 remains Bt unchanged. Thus, the value Δλi, which depends only on the magnitude of the current, can be determined precisely regardless of the magnitude of the effect Δλt in temperature variation in the entire optical fiber for the sensor 310 due to continuous energization.

Fig. 8(d) represents a condition immediately after the energization has terminated. The metalized portion 312a cools rapidly so that the reflected spectrum Sa returns towards the shorter wavelength side. However, it is still in the direction of longer wavelength with respect to the condition before the energization (the condition of Fig. 8(a)) due to the temperature rise in the entire optical fiber for the sensor 310 so that the peak wavelength becomes λ2. Also, the reflected spectrum Sb of the non-metalized portions 312b does not change so that the peak wavelength remains λ2. Accordingly, the reflected spectrum Sa of the metalized portion 312a and the reflected spectrum Sb of the non-metalized portions 312b match.

At this time, although the reflected spectrum of the entire FBG 312 has shifted towards the longer wavelength side with respect to that of the condition before the energization (Fig. 8 (a)), the bandwidth of the reflected spectrum is B0 which is the same as the condition before the energization. Thus, the magnitude of the current can be determined precisely regardless of whether there is the effect Δλt in temperature variation in the entire optical fiber for the sensor 310 due to continuous energization.

Further, after some time period since the energization has terminated, the temperature of the entire optical fiber for the sensor 310 drops so that it returns to the condition before the energization (Fig. 8(a)).

Thus, in accordance with the third embodiment, the single FBG is provided with the current detection portion (the metalized portion 312a) and the temperature detection portion (the non-metalized portions 312b) and the operation is performed based on the reflected bandwidth, so the single FBG 312 can perform temperature assurance (temperature compensation) and precise current or voltage values can be calculated.

Accordingly, even under conditions where heat accumulation due to heat production causes a drift in the wavelength shift, the current value can be precisely calculated.

Also, a single FBG device can realize the FBG 312, so cost increases can be avoided. In particular, no temperature sensor by any external FBG is required, so the cost can be reduced and the entire apparatus can be downsized.

Also, the length of the metalized portion 312a and the length of the non-metalized portions 312b are equal to each other, so their respective reflected spectra show common characteristics (e.g. the same reflectance), so the measurement can be more precise. However, even if their lengths are not equal, measurement is theoretically possible if neither of the lengths are zero. Further, their lengths do not have to be strictly equal, and even if they are slightly different, they can be regarded to be equal if the difference produces only a negligible degree of error in wavelength measurement precision or calculation precision of the current and/or voltage.

Also, themetalizedportion 312a is provided at the center in the axial direction of the FBG 312, so thermal responsiveness of the non-metalizedportions 312b is improved (i.e. the time constant becomes small). However, it does not have to be located at the precise center and the thermal responsiveness of the non-metalized portions 312b can be maintained to some extent if the non-metalized portions 312b are positioned at opposite sides of the metalized portion 312a.

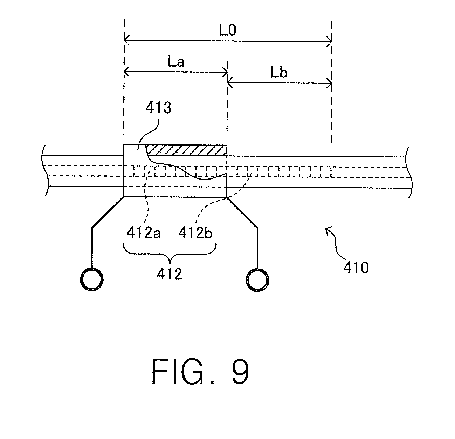

Regardless of the position within the FBG 312 where the metalized portion 312a is provided, the calculation of the current value can be performed with some thermal responsiveness, and for example it can be provided at an end portion as in an alternative embodiment shown in Fig. 9. In the alternative embodiment of Fig. 9, an optical fiber for a sensor 410 comprises an FBG 412 and the FBG 412 comprises a metalized portion 412a (length La) which is sheathed by a metal layer 413 and a non-metalized portion 412b (length Lb) which is not sheathed by the metal layer 413.

In the third embodiment, the current and/or the voltage are measured based on wavelengths of the light reflected by the FBG 312. In an alternative embodiment, the current or the voltage may be measured based on the light that has transmitted through the FBG 312.

## Claims

1. An optical fiber for a sensor comprising:
a Fiber Bragg Grating (FBG) wherein a refractive index of a core of the optical fiber for the sensor changes periodically along a direction in which incident light propagates;
a metal layer for sheathing the FBG; and
a pair of electrodes provided at the metal layer.

2. The optical fiber for the sensor of Claim 1, wherein the metal layer includes a resistive metal material.

3. The optical fiber for the sensor of Claim 1, wherein the metal layer expands and contracts in the direction in which the incident light propagates from Joule heat produced in the metal layer.

4. The optical fiber for the sensor of Claim 1, wherein:
the optical fiber for the sensor comprises a plurality of the FBGs; and
one of the electrodes of the metal layer for one of the FBGs is connected to a resistor.

5. The optical fiber for the sensor of Claim 1, wherein:
the optical fiber for the sensor comprises an environmental temperature sensor portion; and
the environmental temperature sensor portion comprises another FBG.

6. The optical fiber for the sensor of Claim 1, wherein the FBG comprises a metalized portion which is sheathed by the metal layer and a non-metalized portion which is not sheathed by the metal layer.

7. The optical fiber for the sensor of Claim 6, wherein the total length of the metalized portion in the direction in which the incident light propagates and the total length of the non-metalized portion(s) in the direction in which the incident light propagates are equal to each other.

8. The optical fiber for the sensor of Claim 6, wherein the metalized portion is provided at the center of the FBG in the direction in which the incident light propagates.

9. A power device monitoring system, comprising:
the optical fiber for the sensor of Claim 6;
a light source for emitting light constituted by a plurality of wavelengths as the incident light;
spectroscopic means for measuring a bandwidth of light that has transmitted through the FBG or wavelengths reflected by the FBG; and
calculation means for calculating a current flowing through the metal layer or a voltage applied to the metal layer based on the bandwidth.

10. A power device monitoring system, comprising:
the optical fiber for the sensor of Claim 1;
a light source for emitting the incident light; and
light measurement means for measuring light that has transmitted through the FBG or light reflected by the FBG.

11. The power device monitoring system of Claim 10, wherein:
the optical fiber for the sensor comprises a plurality of the FBGs;
the plurality of FBGs include an FBG for current and an FBG for voltage;
the metal layer of the FBG for current is connected in series with the power device;
one of the electrodes of the metal layer of the FBG for voltage is connected to a resistor; and
the metal layer of the FBG for voltage is connected in parallel with the power device.

12. The power device monitoring system of Claim 10, wherein:
the light source emits light constituted by a plurality of wavelengths as the incident light; and
the light measurement means is spectroscopic means for measuring a spectrum of light.

13. The power device monitoring system of Claim 12, wherein:
the spectroscopic means identifies a Bragg wavelength reflected by the FBG; and
the power device monitoring system further comprises calculation means for calculating a current flowing through the metal layer or a voltage applied to the metal layer based on the Bragg wavelength.

14. The power device monitoring system of Claim 13, wherein:
the optical fiber for the sensor comprises an environmental temperature sensor portion;
the environmental temperature sensor portion comprises another FBG;
the spectroscopic means identifies a wavelength reflected by the environmental temperature sensor portion as a reference Bragg wavelength; and
the calculation means calculates the current or the voltage based on a difference between the Bragg wavelength and the reference Bragg wavelength.
